# EUROPEAN PATENT SPECIFICATION

(11) **EP 4 258 295 B1**
(45) Date of publication and mention of the grant of the patent: **09.12.2026**
(21) Application number: 23161690.5
(22) Date of filing: 14.03.2023
(51) Int. Cl.: H01C 1/14, H01C 3/08, H01C 3/12, H01C 1/08, H01C 7/00, H10N 97/00, H10D 1/47, H10W 20/40, H01C 17/075, H10D 89/10

(54) **THIN FILM RESISTOR**
DÜNNSCHICHTWIDERSTAND
RÉSISTANCE À COUCHE MINCE

(30) Priority: 06.04.2022 TW 111112986
(43) Date of publication of application: 11.10.2023
(73) Proprietor: Viking Tech Corporation, Hsinchu County 303 (TW)
(72) Inventor: CHEN, ZHONG-YU, Hsinchu County (TW); CHIU, CHENG-CHUNG, Hsinchu County (TW); KUO, SHUN-HO, Hsinchu County (TW); LU, CHI-YU, Hsinchu County (TW)
(74) Representative: Schwerbrock, Florian

(56) References cited:
- CN-A- 113 113 199
- JP-B2- 4 203 499
- US-A1- 2016 240 291

## Description

### BACKGROUND OF THE INVENTION

### 1. FIELD OF THE INVENTION

The present invention relates to a thin film resistor, in particular to a thin film resistor with high heat dissipation efficiency, as defined in claim 1. Further embodiments are provided in the dependent claims.

### 2. DESCRIPTION OF THE PRIOR ART

A general resistor structure usually includes a rectangular insulating substrate, two electrodes arranged on both sides of the surface, and a resistance layer is arranged on the surface of the substrate between the two electrodes and connected with the two electrodes.

In the resistance adjustment process, the resistance layer is irradiated with laser light to repair and/or adjust the resistance.

The temperature peak locates at the center and gradually decreases to the electrodes for conventional resistor. The heat dissipation path is too long to reduce the heat dissipation efficiency.JP4203499B2 discloses a chip resistor including a pair of electrode portions, a first resistor and a second resistor disposed on an upper surface of the insulation substrate to connect the pair of the electrode portions. It teaches that the second resistor has a lattice shape, the width of which gradually increases toward the electrode.

### SUMMARY OF THE INVENTION

In order to solve the above-mentioned problems, the present invention uses a specific pattern of the resistance layer to shift the temperature peak from the center to the ends close to the electrodes. Therefore, the heat dissipation path is reduced.

The invention provides a thin film resistor, and the resistance layer of the film resistor has a mesh pattern. The mesh pattern includes two mesh densities. The mesh density of the pattern is high near the center of the resistor and low near both electrodes.

The present invention provides a thin film resistor, and the resistance layer of the film resistor has a mesh pattern with a various mesh density. The mesh density increases from the center to both ends of the film resistor.

### BRIEF DESCRIPTION OF THE DRAWINGS

FIG. 1 is a top view of a thin film resistor according to an embodiment of the present invention.
FIG. 2 is a top view of a thin film resistor according to another embodiment of the present invention.
FIG. 3 is a top view of a thin film resistor according to another embodiment of the present invention.

### DESCRIPTION OF THE PREFERRED EMBODIMENTS

Various embodiments of the present invention will be described in detail as below, and the drawings will be used as examples to help readers to have a better understanding. In addition to these detailed descriptions, the present invention can also be widely implemented in other embodiments. The scope of patents should be based on the scope of the claims. It should be noted that the drawings are for illustrative purposes only, and do not represent the actual size or quantity of the components. Some details may not be completely drawn in order to keep the drawings concise.

The present invention provides a thin film resistor. Both ends of the film resistor are electrodes, and a resistance layer on the substrate is between electrodes and connected the electrodes. The resistance layer is formed to have a mesh pattern. The mesh pattern comprises connected multiple mesh portions and different mesh portion has different mesh density. The mesh pattern has a mesh density varies with the position on the film resistor. The mesh pattern can be formed by lithographic etching. The mesh density is high (i.e. fine mesh) near the electrodes and low (coarse mesh) near the center of the film resistor, and the area covered by the coarse mesh is larger than that covered by the fine mesh. Such design distributes the thermal focus from the center to both ends of the film resistor. As a result, the length of the dissipation path is reduced to have a better heat dissipation efficiency.

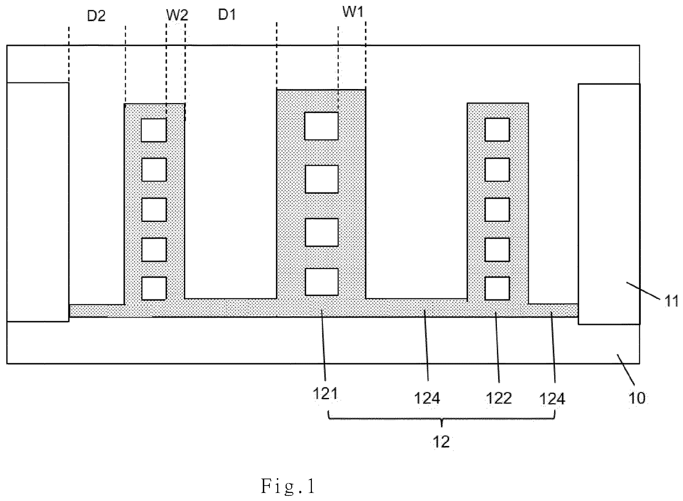

FIG. 1 is a top view of a thin film resistor according to an embodiment of the present invention. In this embodiment, the thin film resistor includes a substrate 10, two electrodes 11 arranged on both ends of the substrate 10, and a resistance layer 12 on the substrate 10 between the two electrodes 11 and connected to the electrodes 11. It is characterized that the resistance layer is formed as a mesh pattern, and the mesh pattern has connected multiple mesh portions. The first mesh portion 121 is a coarse mesh or a low-density mesh near the center. The second mesh portion 122 is a fine mesh or a high-density mesh near the electrode 11. The connection parts 124 are used to connect the electrodes 11, the second mesh portions 122 and the first mesh portion 121.

**In** one embodiment, the area covered by the second mesh portion 122 is smaller than that covered by the first mesh portion 121. The area covered by the second mesh portion 122 is 50~75% of that covered by the first mesh portion 121 area.

Preferably, the wire width W2 of the second mesh portion 122 is 50~75% of the wire width W1 of the first mesh portion 121.

Preferably, the distance D2 between the electrode 11 and the second mesh portion 122 is 50~75% of the distance D1 between the first mesh portion 121 and the second mesh portions 122.

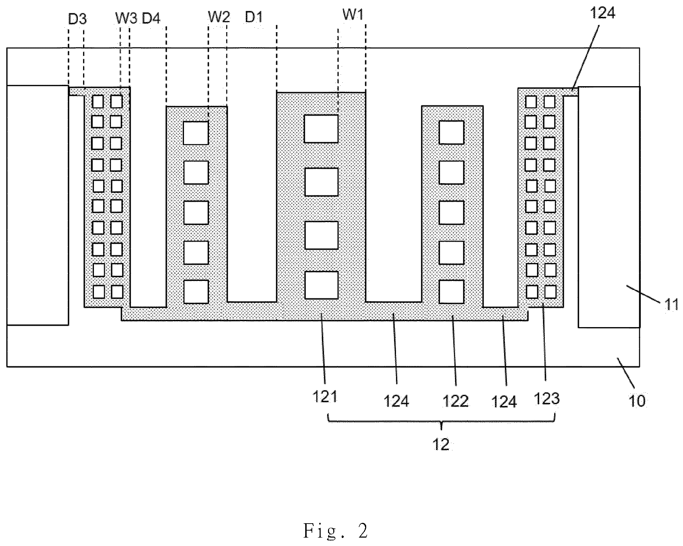

FIG. 2 shows another embodiment. The mesh pattern of the resistance layer 12 further includes a third mesh portion 123 between the second mesh portion 122 and the electrode 11. It is easy to realize that the multiple connection parts 124 are also electrically connected.

**In** this embodiment, the area covered by the first mesh portion 121, the second mesh 122 and the third mesh 123 decreases gradually with a ratio 50~75%.

Preferably, the wire width W1 of the first mesh portion 121, the width W2 of the second mesh portion 122, and the width W3 of the third mesh portion 123, also decreases gradually with a ratio 50~75%.

Preferably, the distance D3 between the electrode 11 and the third mesh portion, the distance D4 between the third mesh portion 123 and the second mesh portion 122, and the distance D2 between the second mesh portion 122 and the first mesh portion 121, also decrease gradually with a ratio 50~75%.

**In** the above embodiment, the first mesh portion 121, the second mesh portion 122 and the third mesh portion 123 are rectangular, and the mesh is also rectangular. Preferably, the area covered and/or wire width of the first mesh portion 121, the second mesh portion 122 and the third mesh portion 123 varies with a ratio 4:2:1.

Obviously, the mesh density gradually increases from the center to the electrode, and the two adjacent mesh portions are getting closer. When the current passes through, the temperature distribution variation is positively related to the mesh density and the thermal peaks are distributed, and the maximum peak will be adjacent to the electrodes to have a better heat dissipation.

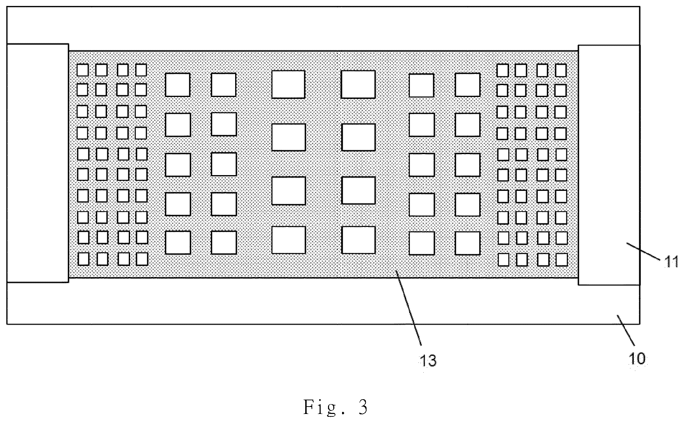

FIG.3. shows another embodiment. The thin film resistor includes at least a substrate 10, two electrodes 11 are arranged on both ends of the substrate 10, and a mesh resistance layer 13 is arranged on the substrate 10 between the two electrodes 11 and electrically connected to the two electrodes 11. The mesh density increases from the center to the electrode 11. Preferably, the area of the mesh resistance layer 13 decreases when the mesh density increases, i.e. decreases from the center to the electrode 11.

The substrate material is aluminum nitride, and the electrode material is copper. Both have high thermal conductivity. The mesh pattern design can enhance the heat dissipation rate.

The mesh resistance layer of the thin film resistor can decrease the temperature near the center and increase the temperature near the electrodes. However, the shifted temperature peak is adjacent to the electrodes to have a shorter dissipation path and a better heat dissipation efficiency. Therefore, the whole temperature of the film resistor is decreased and the temperature distribution is homogenized in the mean while.

## Claims

1. A thin film resistor, comprising:
two electrodes (11) disposed on both ends of a substrate (10); and
a resistance layer (12), disposed on the substrate (10) between the two electrodes (11) and connected to the two electrodes (11), wherein the resistance layer (12) is formed with a mesh pattern (121-122) having a mesh density which increases from the center of the film resistor to the electrodes (11), the mesh pattern (121-122) has a first-density portion (121) near a center of the film resistor and a second-density portion (122) near both ends of the film resistor, wherein the first-density portion (121) is a low-density mesh portion and the second-density portion (122) is a high-density mesh portion;
wherein a second distance (D2) between the second-density portion (122) and the electrode (11), is 50~75% of a first distance (D1) between the first-density portion (121) and the second-density portion (122);
wherein a second area covered by the second-density portion (122), is 50~75% of a first area covered by the first-density portion (121); and
wherein a wire width (W2) of the second-density portion (122) is 50~75% of a wire width (W1) of the first-density portion (121).

2. The thin film resistor according to claim 1, wherein the mesh pattern (121-123) further includes a third-density portion (123) between the second-density portion (122) and the electrode (11), wherein the third-density portion (123) is a middle-density mesh portion.

3. The thin film resistor according to claim 2, wherein a
third distance (D3) between the electrode (11) and the third-density portion (123) is 50~75% of a fourth distance (D4) between the third-density portion (123) and the second-density portion (122).

4. The thin film resistor according to claim 2, wherein a
third area covered by the third-density portion (122), is 50~75% of the second area covered by the second-density portion (123).

5. The thin film resistor according to claim 2, wherein a
wire width (W3) of the third-density portion (122) is 50~75% of the wire width (W2) of the second-density portion (122).

6. The thin film resistor according to claim 2, wherein the
first-density portion (121), the second-density portion (122) and the third-density portion (123) are rectangular.

7. The thin film resistor according to claim 1, wherein material of the substrate (10) is aluminum nitride, and material of the electrodes (11)is copper.

## Patentansprüche

1. Dünnschichtwiderstand, umfassend:
zwei Elektroden (11), die an den beiden Enden eines Substrats (10) angeordnet sind; und
eine Widerstandsschicht (12), die auf dem Substrat (10) zwischen den beiden Elektroden (11) angeordnet und mit den beiden Elektroden (11) verbunden ist, wobei die Widerstandsschicht (12) mit einer Netzstruktur (121-122) ausgebildet ist, die eine Netzdichte aufweist, die von der Mitte des Filmwiderstands zu den Elektroden (11) hin zunimmt, wobei die Netzstruktur (121-122) einen Abschnitt erster Dichte (121) nahe der Mitte des Dünnschichtwiderstands und einen Abschnitt zweiter Dichte (122) nahe den beiden Enden des Filmwiderstands aufweist, wobei der Abschnitt erster Dichte (121) ein Netzabschnitt mit niedriger Dichte ist und der Abschnitt zweiter Dichte (122) ein Netzabschnitt mit hoher Dichte ist;
wobei ein zweiter Abstand (D2) zwischen dem Abschnitt zweiter Dichte (122) und der Elektrode (11) 50~75 % eines ersten Abstands (D1) zwischen dem Abschnitt erster Dichte (121) und dem Abschnitt zweiter Dichte (122) beträgt;
wobei eine zweite Fläche, die vom Abschnitt zweiter Dichte (122) bedeckt ist, 50~75 % einer ersten Fläche ausmacht, die vom Abschnitt erster Dichte (121) bedeckt ist; und
wobei eine Bahnbreite (W2) des Abschnitts zweiter Dichte (122) 50~75 % einer Bahnbreite (W1) des Abschnitts erster Dichte (121) beträgt.

2. Dünnfilmwiderstand gemäß Anspruch 1, wobei die Netzstruktur (121-123) ferner einen Abschnitt dritter Dichte (123) zwischen dem Abschnitt zweiter Dichte (122) und der Elektrode (11) aufweist, wobei der Abschnitt dritter Dichte (123) ein Netzabschnitt mittlerer Dichte ist.

3. Dünnfilmwiderstand gemäß Anspruch 2, wobei ein dritter Abstand (D3) zwischen der Elektrode (11) und dem Abschnitt dritter Dichte (123) 50~75 % eines vierten Abstands (D4) zwischen dem Abschnitt dritter Dichte (123) und dem Abschnitt zweiter Dichte (122) beträgt.

4. Dünnfilmwiderstand gemäß Anspruch 2, wobei eine dritte Fläche, die vom Abschnitt dritter Dichte (122) bedeckt ist, 50~75 % der zweiten Fläche, die vom Abschnitt zweiter Dichte (123) bedeckt ist, beträgt.

5. Dünnfilmwiderstand gemäß Anspruch 2, wobei eine Bahnbreite (W3) des Abschnitts dritter Dichte (122) 50~75 % der Bahnbreite (W2) des Abschnitts zweiter Dichte (122) beträgt.

6. Dünnfilmwiderstand gemäß Anspruch 2, wobei der Abschnitt erster Dichte (121), der Abschnitt zweiter Dichte (122) und der Abschnitt dritter Dichte (123) rechteckig sind.

7. Dünnfilmwiderstand gemäß Anspruch 1, wobei das Material des Substrats (10) Aluminiumnitrid ist und das Material der Elektroden (11) Kupfer ist.

## Revendications

1. Une résistance à film mince, comprenant :
Deux électrodes (11) placées aux deux extrémités d'un substrat (10) et une couche de résistance (12) déposée sur le substrat (10) entre les deux électrodes (11) et connectée aux deux électrodes (11), où la couche de résistance (12) est constituée d'un motif en maille (121 - 122) ayant une densité de maillage qui augmente entre le centre de la résistance à film et les électrodes (11), où le motif en maille (121 - 122) comporte une portion de première densité (121) près d'un centre de la résistance à film et une portion de deuxième densité (122) près des deux extrémités de la résistance à film, où la portion de première densité (121) est une portion de maillage à faible densité et la portion de deuxième densité (122) est une portion de maillage à haute densité,
où une deuxième distance (D2) entre la portion de deuxième densité (122) et l'électrode (11) est égale à 50 ~ 75 % d'une première distance (Dl) entre la portion de première densité (121) et la portion de deuxième densité (122), où une deuxième zone couverte par la portion de deuxième densité (122) est égale à 50 ~ 75 % d'une première zone couverte par la portion de première densité (121), et
où une largeur de piste (W2) de la portion de deuxième densité (122) est égale à 50 ~ 75 % d'une largeur de piste (W1) de la portion de première densité (121).

2. La résistance à film mince selon la revendication 1, où le motif en maille (121 - 123) comprend en outre une portion de troisième densité (123) entre la portion de deuxième densité (122) et l'électrode (11), où la portion de troisième densité (123) est une portion de maillage de moyenne densité.

3. La résistance à film mince selon la revendication 2, où une troisième distance (D3) entre l'électrode (11) et la portion de troisième densité (123) est égale à 50 ~ 75 % d'une quatrième distance (D4) entre la portion de troisième densité (123) et la portion de deuxième densité (122).

4. La résistance à film mince selon la revendication 2, où une troisième zone couverte par la portion de troisième densité (122) est égale à 50 ~ 75 % de la deuxième zone couverte par la portion de deuxième densité (123).

5. La résistance à film mince selon la revendication 2, où une largeur de piste (W3) de la portion de troisième densité (122) est égale à 50 ~ 75 % de la largeur de piste (W2) de la portion de deuxième densité (122).

6. La résistance à film mince selon la revendication 2, où la portion de première densité (121), la portion de deuxième densité (122) et la portion de troisième densité (123) sont rectangulaires.

7. La résistance à film mince selon la revendication 1, où le matériau du substrat (10) est du nitrure d'aluminium et le matériau des électrodes (11) du cuivre.
